# EUROPEAN PATENT SPECIFICATION

(11) **EP 1 453 173 B1**
(45) Date of publication and mention of the grant of the patent: **29.12.2010**
(21) Application number: 02779908.9
(22) Date of filing: 08.10.2002
(51) Int. Cl.: H02H 7/085, H02H 3/08, G01R 33/06, H02H 1/00, G01R 15/20

(54) **OVERLOAD CURRENT PROTECTION APPARATUS**
ÜBERLASTSTROMSCHUTZVORRICHTUNG
DISPOSITIF DE PROTECTION CONTRE LE COURANT DE SURCHARGE

(30) Priority: 09.10.2001 JP 2001311282
(43) Date of publication of application: 01.09.2004
(73) Proprietor: Fuji Electric FA Components & Systems Co., Ltd., Chuo-ku Tokyo 103-0011 (JP)
(72) Inventor: KUDO, Takahiro, FUJI ELECTRIC CO., LTD c/o, Kawasaki, Kanagawa 210-9530 (JP); TANAKA, Junzo, FUJI ELECTRIC CO., LTD c/o, Kawasaki, Kanagawa 210-9530 (JP); ISHIKAWA, Kimitada, FUJI ELECTRIC CO., LTD c/o, Kawasaki, Kanagawa 210-9530 (JP)
(74) Representative: MERH-IP Matias Erny Reichl Hoffmann
(86) International application number: PCT/JP2002/010438
(87) International publication number: WO 2003/032461

(56) References cited:
- EP-A- 0 669 691
- JP-A- 9 033 257
- JP-A- 63 138 258
- JP-A- 2000 055 996
- JP-A- 2002 247 749
- JP-A- 2002 247 750
- JP-A- 2002 247 751

## Description

### Field of the Invention

The present invention relates to a device that detects the magnitude of current flowing through a conductor and shuts off the current when the magnitude of the current has exceeded a previously given threshold value. More particularly, the present invention relates to an overload-current security device capable of controlling power to be supplied to a load such as an electric motor.

### Description of Background Arts

Any overload-current security device detects that the current flowing through a load such as a three-phase motor via a contactor has exceeded a safe threshold value, and then, in response to the detected result, shuts off the current flowing to a motor load. These processes have thus been realized by causing part or all of the motor current to flow to a bi-metal switching element. Concretely, it is so arranged that, by conducting current to a switch consisting of a bi-metal component, the bi-metal component is heated in correspondence with the intensity of the current, and then, when the motor current has exceeded a safe threshold value for more than a regulated duration, heat causes the bi-metal component to bend so as to hold a switch contact in the open condition, thus causing the suspension of the power supply to the control input terminal of a contactor. However, the above system using the bi-metal switch involves difficulty in the current adjustment when the switch is opened, and thus the incorrectly adjusted condition is apt to remain a problem for some time.

To cope with this, it has become possible to electronically perform the function previously realized using the bi-metal switch. As a result of the use of electronic equipment, reliability has been enhanced and adjustment can be executed readily. On the other hand, in cases in which electronic equipment is used, the constitution of the circuit becomes complex and thus, in order to properly detect current and operate a contactor, a constant-voltage regulated power-supply source and a large number of component parts are essentially required. In addition, although a current detection transformer has thus been used as a means for detecting current, this device also involves the problem of the current detectable range not being able to be fully secured due to magnetic saturation caused by the presence of an iron core. As a means for detecting current, there is a method applying a magnetoresistive element. However, this method requires the provision of an iron core due to the low sensitivity of the magnetoresistive element, and thus, as in the case of the current detection transformer, this method can hardly secure a broad range for detecting current.

To cope with this, as a highly sensitive magnetism detection element for replacing the Hall element and the magnetoresistive element, a magnetic impedance element using amorphous wires has previously been constituted (refer to Patent Document 1 for an example). Further, another art has constituted an amorphous magnetic thin film formed via a sputtering method (refer to Patent Document 2 for an example).

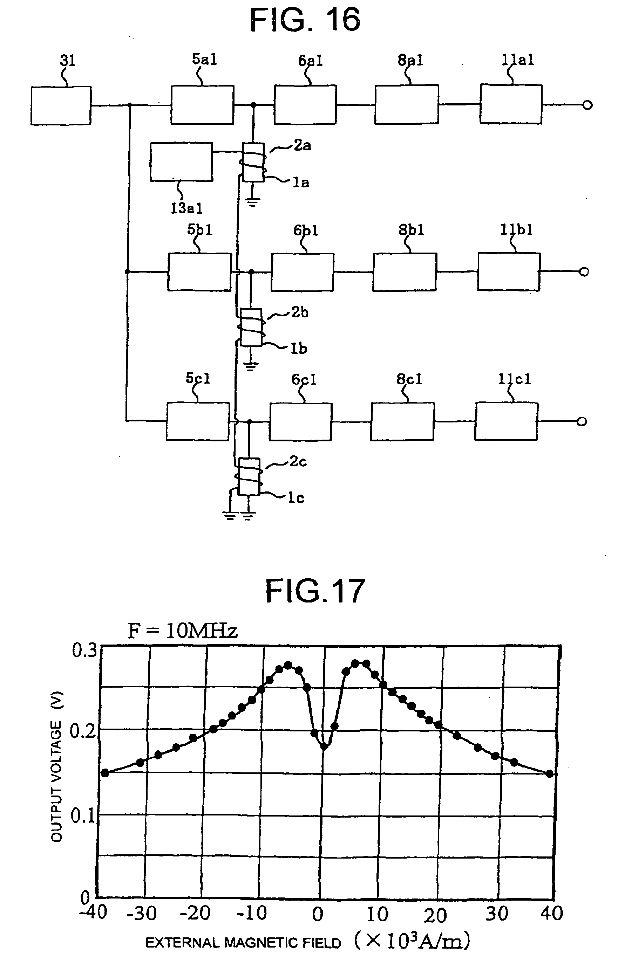

However, even when a magnetic impedance element having an optional form is used, the magnetic impedance element shows its high sensitivity in its magnetism detection characteristics. However, as shown in FIG. 17, variation in the impedance against the magnetic field of an amorphous wire element indicates non-linear characteristics, and thus, linear output cannot be secured (refer to Patent Document 3 for an example). For this reason, the method for adding an AC bias magnetic field to the magnetic impedance element is such that the linear output against the magnetic field is ensured by the difference in the variation of the magnetic impedance element generated from the sum of the positive and negative magnetic fields generated by the AC bias magnetic field and the immeasurable external magnetic field (refer to Patent Document 4 for an example).
[Patent Document 1]
   Laid-Open Japanese Patent Publication No. HEI-06-281712 (1994), (page 4, FIG. 5 ~ FIG. 12)
[Patent Document 2]
   Laid-Open Japanese Patent Publication No. HEI-08-075835 (1996), (pages 4~5. FIG. 1 ~ FIG. 6)
[Patent Document 3]
   Laid-Open Japanese Patent Publication No. 2000-055996, (page 3, FIG. 23)
[Patent Document 4]
   Laid-Open Japanese Patent Publication No. HEI-09-127218 (1997), (pages 4~5, FIG. 3)

Incidentally, in principle, the magnetic impedance element generates a magnetic impedance effect, and thus it is necessary to add several mA of at least several MHz of high-frequency current to this element, thereby increasing the power consumption and expanding the size of the power-supply transformer, thus making it difficult to downsize and reduce the cost of the equipment.

FIG. 16 shows an example of a conventional detecting circuit using a magnetic impedance element.

This shows an example of the common sharing of an oscillating means 31 and a bias-current adding means 13a1. Inasmuch as several mA of current and about several tens of mA of bias current are constantly added to magnetism detection elements 1a, 1b, and 1c, the consumable power increases in proportion to the number of elements. Further, it is also required to provide wave detection means 6a1, 6b1, and 6c1, holding means 8a1, 8b1, and 8c1, and amplifying means 11a1,11b1, and 11c1 in proportion to the number of magnetism detection elements. As a result, this constitution unavoidably expands the scope of circuitry, thus further increasing the cost for the provision of component parts.

The document EP 0 669 691 discloses an overload-current security device, comprising a plurality of switching unitsadapted to individually switch the current supplied from a power-supply source to a load; a current detector adapted to detect the current supplied from said power-supply source to said load; and a controlling power-supply source for supplying electrical power to each of said component elements. The overload-current security device is adapted to interrupt, upon detection of an overload-current, the power supplied to said load. The current detector comprises: a plurality of magnetism detection elements that individually incorporate their own magnetic impedance effect and are arranged so as to be compatible with individual phases of power-supply sources; a DC current supply means adapted to supply DC current to each of said magnetism detection elements; a compensation-current supply means that comprises a plurality of compensation conductors each integrated into a respective one of said magnetism detection elements, first switches, and a compensation-current adding means, wherein said compensation-current supply means is arranged to supply current selectively to each of said compensation conductors via a respective first switch; a plurality of wave detection means that are individually disposed In correspondence with each of said magnetism detection elements so as to convert the compensation-current of the compensation conductor selected by said first switches into a voltage, said wave detection means including a common current-voltage conversion means, a plurality of pairs of a second switch and an amplifier, each pair disposed in correspondence with a respective one of said compensation conductors, the second switches being adapted to selectively output the voltage of said common current-voltage conversion means to the respective amplifier; a holding means adapted to individually hold the output from a selected one of said wave detection means; and an amplifying means adapted to amplify the voltage held by said holding means. The overload-current security device enables said current detector to detect the current for each individual phase based on selective operations performed by said first and second switches.

Accordingly, the present invention has been developed in light of the above background arts. The object of the present invention is to provide a downsized and low-cost overload-current security device that enables the provision of a low-cost power-supply source by dispensing with a constant-voltage regulated power-supply source, and further allows expansion of the current detection range.

### DISCLOSURE OF THE INVENTION

This object is achieved by an overload-current security device as claimed in claim 1. Preferred embodiments of the invention are defined in the dependent claims.

More particularly, according to the present invention, in order to constitute a current detection means, it is arranged such that, by applying magnetism detection elements individually incorporating the magnetic impedance (MI) effect, unlike any conventional current detection transformer in widespread use, the current detection range has been expanded so as to prevent magnetic saturation caused by an iron core. Further, the controlling power-supply source dispenses with the external supply of a constant-voltage regulated power source. As a result, it is possible to provide an overload-current security device that features versatile applicability and is capable of decreasing the total cost.

When a multi-phase AC power-supply source Is used, there is no need to provide a power-supply transformer for each phase, making it possible to provide an overload-current security device that is fitted with a smaller number of component parts and is low in cost. In this case, It is allowable to provide a security device with a single unit of oscillating means instead of the conventional method of providing the oscillating means for each phase. Through an arrangement such that AC current is added only when any of the elements and devices disposed for each phase has been selected. This makes it possible to decrease power consumption. Power consumption is further lowered by solely feeding power to the bias coils when current is detected. Further, power consumption can be decreased by activating operation of the oscillating means only when current is detected.

Further, the security device is fitted with a single system of holding means and amplifying means, thus further reducing power consumption and lowering cost. Through an arrangement such that the positive- and negative-bias magnetic fields are alternately added to the magnetism detection elements so as to determine the difference between detected voltages at the time of applying individual bias magnetic field, it is not only possible to improve the output linearity but, by using pulses to perform intermittent driving of the system in place of the conventional AC biasing system, it is also possible to further decrease the power consumption.

In addition, by integrating the magnetism detection elements, AC-current input terminals of individual magnetism detection elements, bias coils, and current input terminals thereof through the use of a resinous molding process, it is possible to decrease the magnetic resistance and bias current, thus facilitating downsizing. Further, by integrating the magnetism detection elements, AC-current input terminals thereof, bias coils and bias-current input terminals, and a circuit that outputs signals proportional to the signals output from the magnetism detection elements, it is possible to enhance the S/N (signal-to-noise) ratio. In particular, by enabling the function of the system to be improved by means of various corrective data incorporated therein, it is possible to realize a system featuring excellent environmental resistance, high precision, and lower power consumption. In addition, through the application of thin-film-type magnetism detection elements, the overload-current security device eliminates the adverse influence of variable output caused by strain, which becomes a problem with the wire-type elements, thus realizing minimum power consumption with high precision.

### BRIEF DESCRIPTION OF THE DRAWINGS

- FIG. 1: is a schematic block diagram of the overload-current security device according to the first embodiment of the present invention;
- FIG. 2: is a schematic block diagram of the magnetism detection unit;
- FIG. 3a: is a schematic block diagram of the first magnetism detection unit;
- FIG. 3b: is a time chart designating the operations of the switches shown in FIG. 3a;
- FIG. 3c: is explanatory of the operating timing of an oscillating means;
- FIG. 3d: is a partial constitution of an example that is a variation of that shown in FIG. 3a;
- FIG. 3e: is a time chart designating the operation of the varied example shown in FIG. 3d;
- FIG. 4: is a schematic block diagram concretely designating those individual component elements shown in FIG. 3a;
- FIG. 5: is a schematic block diagram of the second magnetism detection unit;
- FIG. 6: is explanatory of the positive and negative biases;
- FIG. 7: is a schematic block diagram concretely designating those individual component elements shown in FIG. 5;
- FIG. 8: shows the circuitry of another example of an oscillating means;
- FIG. 9: is a schematic block diagram of the overload-current security device according to the second embodiment of the present invention;
- FIG. 10: is a concrete example of the constitution of a transformer;
- FIG. 11: is a perspective view of a concrete example of the constitution of a magnetic sensor;
- FIG. 12: is explanatory of the serial processes for producing the magnetic sensor shown in FIG. 11;
- FIG. 13: is explanatory of the loaded magnetic sensor shown in FIG. 11;
- FIG. 14: is explanatory of the magnetic shielding configuration;
- FIG. 15: is a perspective view of a concrete example of the magnetism detection unit;
- FIG. 16: is a schematic block diagram of a conventional magnetism detection unit; and
- FIG. 17: is a chart explanatory of the magnetic impedance characteristics of an amorphous wire.

### BEST MODE FOR IMPLEMENTING THE INVENTION

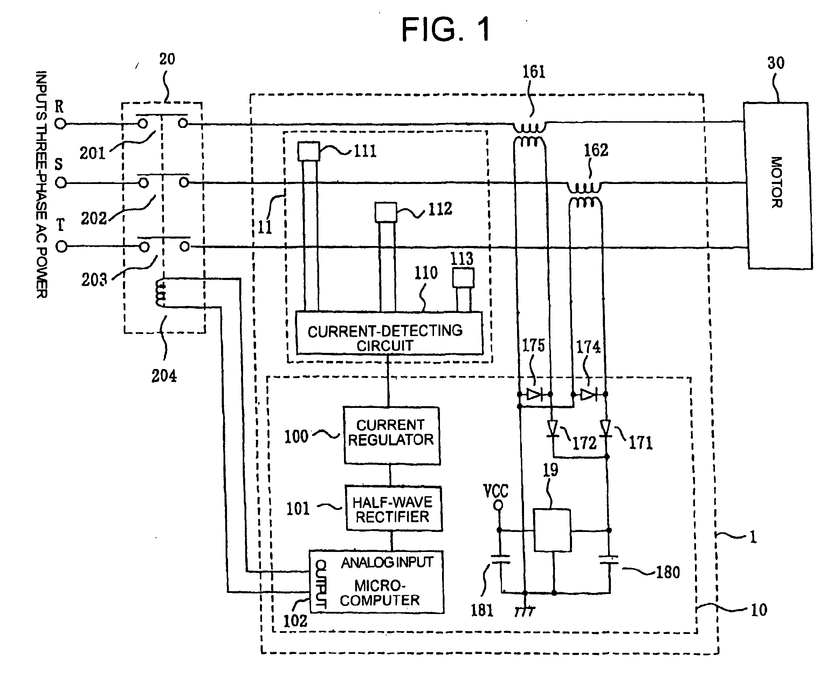

The present invention is described below. FIG. 1 is a schematic block diagram of the overload-current security device according to the first embodiment of the present invention.

In FIG. 1, a plurality of power-supply lines R, S, and T, respectively connected to a three-phase AC power-supply source (not shown), are linked with a motor 30 via a three-phase contactor 20 and a pair of power-supply transformers 161 and 162. A current detection unit 11 detects current supplied via the power-supply lines R, S, and T for each phase. Even when one of the three phases incurs disconnection, it is required that the entire system be operated normally. Due to such needs, this embodiment introduces a pair of power-supply transformers 161 and 162. However, it is also allowable to dispose this transformer for each phase. The contactor 20 is fitted with three contacts 201, 202, and 203, and each of these contacts is linked with the motor 30 via the primary coils of the power-supply transformers 161 and 162, which are directly or individually connected to the power-supply lines R, S, and T. The three contacts are mechanically united with each other so that they can be simultaneously driven by an electro-magnetic coil 204 connected to a control circuit 10. The above-mentioned current detection unit 11, a pair of power-supply transformers 161 and 162, and the control circuit 10 jointly constitute an electronic overload relay unit 1. Signals output from the current detection unit 11 are amplified by a current regulator (gain adjuster) 100 in correspondence with a preset current value. After being amplified, the signals output from the current detection unit 11 are delivered to the analog input of a micro-computer (i.e., a personal computer) 102 via a half-wave rectifier 101.

In the controlling power-supply source shown in FIG. 1, a first capacitor 180 is connected to the secondary coils of the power-supply transformers 161 and 162 via a pair of rectifying diodes 171 and 172. Protecting diodes 174 and 175 are respectively linked between the anode and the ground of the circuit. The first capacitor 180 is linked between the positive input of a voltage adjuster 19 and the ground of the circuit. A second capacitor 181 is linked between the positive output and the ground of the circuit, thus enabling the voltage adjuster 19 to output a constant voltage level VCC, which then constitutes the power-supply source of the electronic overload relay unit 1.

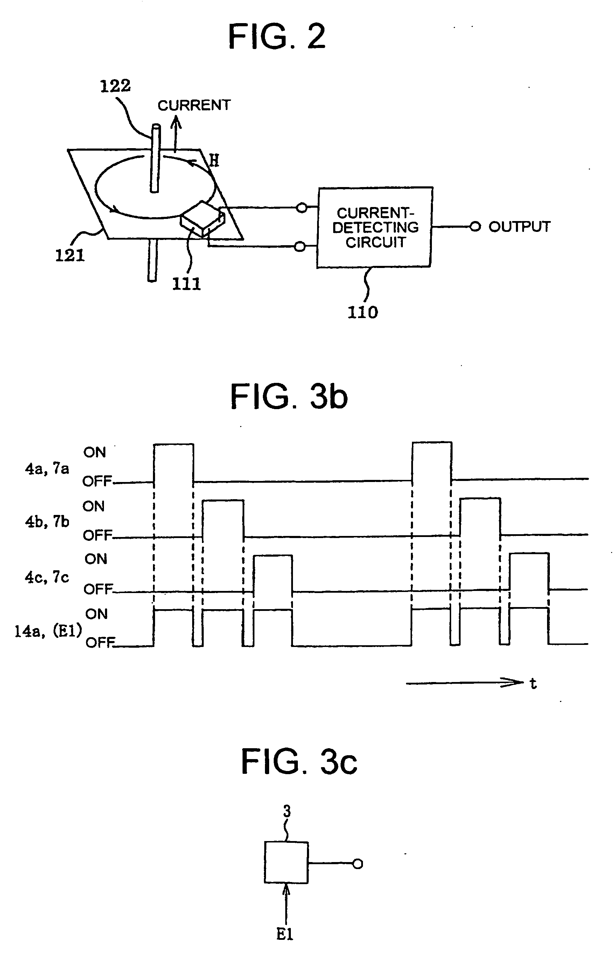

FIG. 2 designates a simplified configuration of a current detection unit.

The reference numeral 111 shown in FIG. 2 designates a magnetic impedance element (MI element), 122 designates the wiring for conducting current for each phase, 121 designates a substrate for fixedly securing the wiring 122 and the MI element 111, and 110 designates a detection circuit.

In order to constitute the MI element 111, it is allowable to apply either of the amorphous wire disclosed in the above-mentioned Laid-Open Japanese Patent Publication No. HEI-06-281712 (1994) and the thin-film applied magnetic impedance element disclosed in the Laid-Open Japanese Patent Publication No. HEI-08-075835 (1996). FIG. 2 designates an MI element corresponding to a single phase. However, each phase comprises an identical constitution.

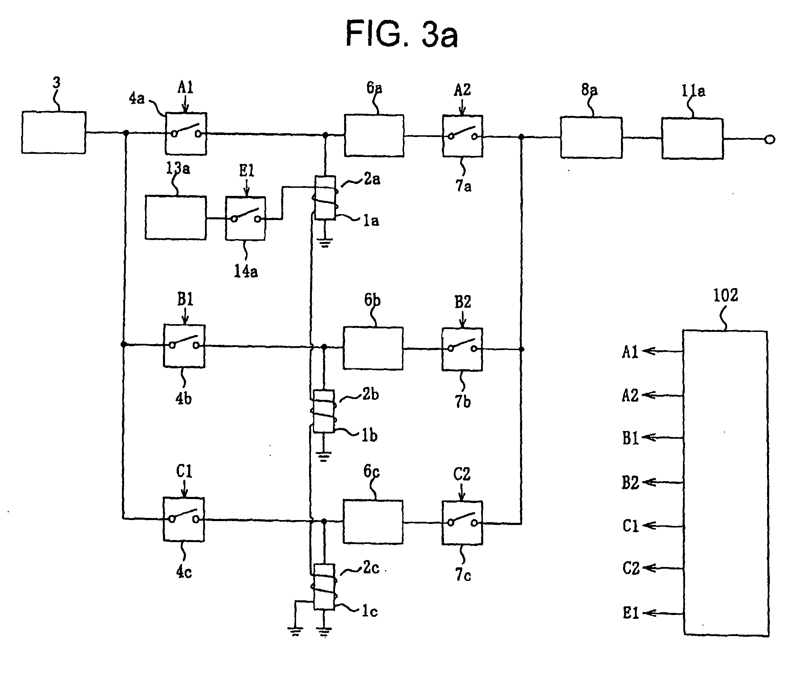

FIG. 3a exemplifies the first constitution of the current detection unit.

The reference numerals 1a, 1b, and 1c respectively designate an MI element consisting of the wire form or the thin-film form. The reference numerals 2a, 2b, and 2c respectively designate a bias coil for feeding bias to the MI elements 1a, 1b, and 1c. The reference numeral 3 designates an oscillating circuit. The reference numerals 4a, 4b, and 4c respectively designate a first switch. The first switches 4a, 4b, and 4c individually switch signals output from the oscillating circuit 3, and then add high-frequency AC current to the MI elements 1a, 1b, and 1c. The reference numeral 13a designates a second current-adding means that feeds current to the bias coils 2a, 2b, and 2c, where the operation for feeding the current is turned ON and OFF by a third switch 14a. The reference numerals 6a, 6b, and 6c respectively designate a wave- detecting means that outputs the peak value of the varied impedance of the MI elements 1a, 1b, and 1c, converted into varied voltages. The reference numerals 7a, 7b, and 7c respectively designate a second switch for extracting output signals from the wave detection means in correspondence with the selected MI element. The reference numeral 8a designates a first holding means that holds the output signal from the wave detection means 6a, 6b, and 6c. The reference numeral 11a designates an amplifying means for amplifying output signals from the first holding means 8a.

In response to any of those control signals A1, A2, B1, B2, C1, and C2 for the first switches 4a, 4b, and 4c and the second switches 7a, 7b, and 7c, the micro-computer 102 selects any of the MI elements 1a, 1b, and 1c, and further outputs a control signal E1 for delivering bias current.

More particularly, in response to the control signals A1 or A2, the MI element 1a is selected. Likewise, in response to the control signals B1 or B2, the MI element 1b is selected. Likewise, in response to the control signals C1 or C2, the MI element 1c is selected. In addition, in response to the control signal E1, bias current is delivered to any of these MI elements 1a, 1b, and 1c. Accordingly, it is possible to add AC current and bias current to any of the MI elements consuming the majority of consumable power solely for a duration in which any of the control signals has been selected, thus making it possible to minimize the consumed power. For example, when the MI element 1a is driven, the first switch 4a and second switch 7a are turned ON at substantially the same time, and the control signal E1 is simultaneously output only once to cause the third switch 14a to be turned ON, thus lowering power consumption. Further, inasmuch as the first holding means 8a and the amplifying means 11a can be constituted using a single system, this further facilitates a decrease in power consumption and running cost.

In terms of the timing after operation of the MI element 1a is activated, it is so arranged that the first switch 4b and second switch 7b are turned ON at substantially the same time, and the control signal E1 is simultaneously output only once to cause the third switch 14a to be turned ON, thereby causing the MI element 1b to be turned ON in order to further cause the first switch 4c and the second switch 7c to be turned ON at substantially the same time. Simultaneously, the control signal E1 is output only once to cause the third switch 14a to be turned ON, thereby activating operation of the MI element 1c. FIG. 3b exemplifies the above sequential operations in a timing chart.

Further, as shown in FIG. 3c, by causing the oscillating means 3 to activate based on the timing for operating the third switch in response to the control signal E1, it is so arranged that the oscillating means 3 can execute oscillating operation only when bias current is being fed to the bias coils 2a, 2b, and 2c, and thus, in contrast to the case of causing the oscillating means 3 to continuously execute oscillating operations, it is possible to further lower the power consumption.

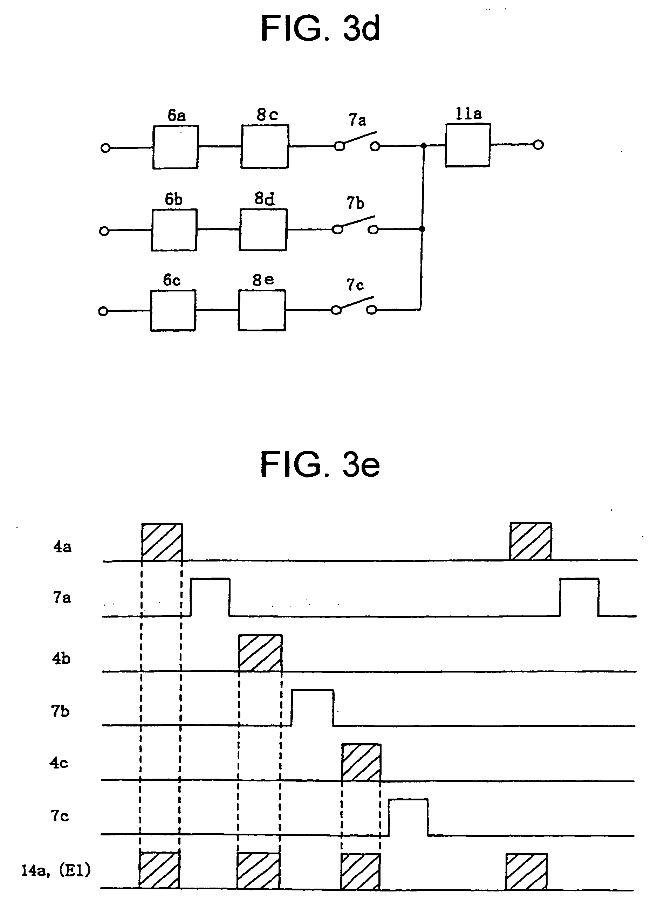

FIG. 3d shows an example that is a variation of that shown in FIG. 3a. As is apparent from FIG. 3d, instead of the holding means 8a provided in common with the wave detection means 6a, 6b, and 6c shown in FIG. 3a, the variation shown in FIG. 3d individually provides the wave detection means 6a, 6b, and 6c with the holding means 8c, 8d, and 8e, respectively. Like that shown in FIG. 3a, the first switch and the third switch are turned ON at substantially the same time; however, due to the above arrangement, it is possible to optionally select the operating timing of the second switches 7a, 7b, and 7c, which can be integrally unified into a single unit. FIG. 3e shows an example of the timing chart when they are combined into a single unit.

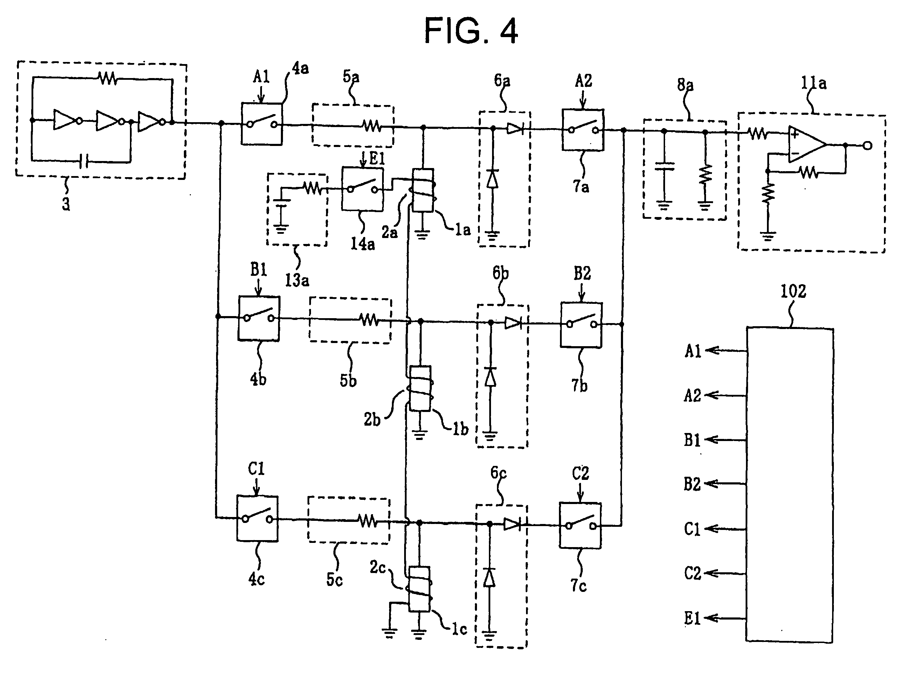

FIG. 4 designates a concrete example of the arrangement shown in FIG. 3a.

There are a variety of methods for constituting the oscillating means 3, including the application of a quartz oscillator or transistor. In this embodiment, the oscillating means 3 consists of a CMOS gate as an example. The wave detection means 6a, 6b, and 6c can respectively be constituted using analog switches. However, in this embodiment, diodes are used to constitute the wave detection means 6a, 6b, and 6c. The first holding means 8a is constituted using a resistor and capacitor. Although the amplifying means 11a can be constituted using a transistor, this embodiment has introduced an operational amplifier to constitute the amplifying means 11 a as an example. The first, second, and third switches are respectively constituted with relays or analog switches. For the purpose of lowering the current to be fed to the MI elements 1a, 1b, and 1c, current limit resistors 5a, 5b, and 5c are provided. However, these current limit resistors may be deleted.

Those circuits shown in FIG. 3a and FIG. 4 each feature a simplified constitution to readily facilitate the detection of magnetism. However, the output precision is not satisfactory. This is due to the fact that, as shown in FIG. 17, the variation in impedance against the magnetic field of amorphous wire elements contains non-linearity.

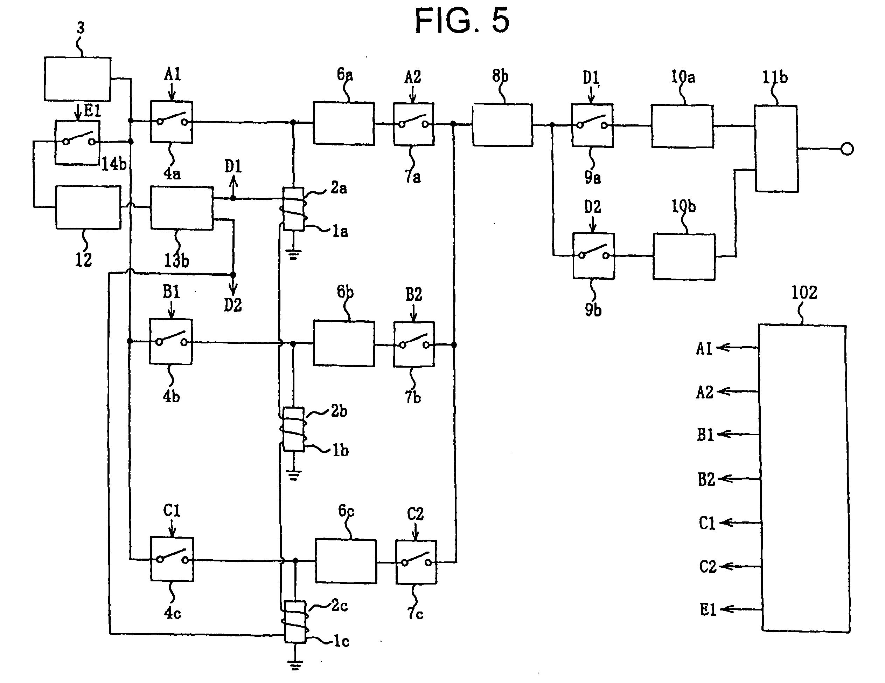

FIG. 5 exemplifies the second constitution with an improvement in the non-linear characteristics. The difference from that shown in FIG. 3a is generated by the improved output linearity resulting from computation of the difference in the detected voltages with individual bias magnetic fields added after the positive- and negative-bias magnetic fields are alternately added to the MI elements 1a, 1b, and 1c.

The reference numeral 12 designates a frequency-dividing means for dividing the frequency of the output signal from the oscillating means 3. The dividing means 12 outputs signals containing a frequency lower than that of the AC current fed to the MI elements 1a, 1b, and 1c. The reference numeral 13b designates a second current-adding means for alternately adding positive- and negative-bias magnetic fields in response to the positive and negative output timings delivered from the frequency-dividing means 12, where the second current-adding means 13b adds the output signal of the oscillating means 3 divided by the frequency-dividing means 12 via the third switch 14b to the bias coils 2a, 2b, and 2c. The circuit shown in FIG. 5 is further fitted with the following: a first holding means 8b for holding a voltage compatible with variations in impedance caused by the positive- and negative-bias magnetic fields of the MI elements 1a, 1b, and 1c; a pair of second holding means 10a and 10b for holding the voltage output from the first holding means 8b based on the positive and negative timings; a pair of fourth switches 9a and 9b operated by the above timings D1 and 2; and a differential amplifying means 11b for differentially amplifying the voltage output from the second holding means 10a and 10b.

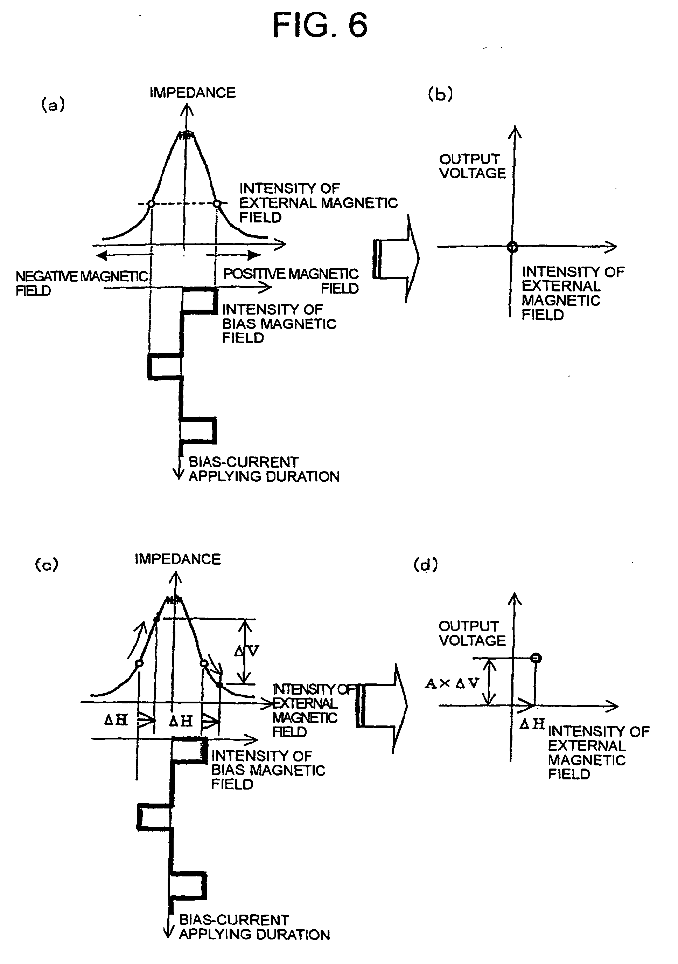

FIG. 6 is explanatory of the operations of the positive and negative biases. Note that the operating characteristics of the sensors (i.e., the MI elements) against the magnetic field shown in FIG. 6 are also those of a conventional magnetic impedance element.

FIGS. 6(a) and (b) are respectively explanatory of the operating characteristics when the bias magnetic field is added while the external magnetic field remains zero. FIG. 6(a) schematically shows the operating characteristics when the bias magnetic field consisting of even intensity of the positive and negative magnetic fields is added to a magnetic impedance element under the condition that no appreciable external magnetic field out of the measurable range is present. The chart shown in FIG. 6(a) also designates a portion representing the variation in impedance against variations in the intensity of the external magnetic field, and another variation caused by the intensity of the bias magnetic field added to the magnetic impedance element and the adding duration.

Generally, the impedance characteristics do not show a smooth curve in areas in which the intensity of the external magnetic field remains zero; however, at such a point at which the polarity of the magnetic field is variable, unstable characteristics are generated. The blank circles shown on the impedance-characteristic curves designate the impedance values acquired from the values of the maximum positive/negative-bias magnetic fields generated by the bias magnetic field that periodically oscillates the positive and negative magnetic fields with a rectangular waveform. Based on the relationship between the values and the high-frequency current available for the driving added to the magnetic impedance element, an output voltage can be obtained. The difference in output voltages between the two points is detected.

As a result, in cases in which there is no appreciable external magnetic field out of the measurable range, the output voltages at two points are identical, and thus no difference exists. Due to this, as shown in FIG. 6(b), after a differential amplifying operation is performed, the output becomes zero.

On the other hand, the charts shown in FIGS. 6(c) and (d) are explanatory of the operation at the moment of the addition of bias when a measurable external magnetic field exists.

FIG. 6(c) presents a schematic chart designating the characteristics in cases in which a AH positive magnetic field has been sensed as the external magnetic field out of the measurable range. Blank circles shown on the curves for designating the impedance characteristics respectively represent the impedance values obtained from the maximum values of the positive and negative magnetic fields of bias. These blank circles shift to the black-dot position due to the influence of the external magnetic field ΔH. In opposition to the black dots at a pair of points generated on the part of the positive magnetic field and on the part of the negative magnetic field of the oscillating bias magnetic field, the polarity of the voltage is defined by the direction that can be determined by subtracting a voltage value corresponding to the black dots on the part of the positive magnetic field from a voltage value corresponding to the black dot on the part of the negative magnetic field.

Accordingly, the obtainable difference in the output voltages (differential output) becomes AV of the positive voltage, and thus, when an external magnetic field out of the measurable range AH has been sensed, as shown in FIG. 6(d), assuming that the amplifying rate of the differential amplifier is A, then, A x AV is obtained as the output measured following the differential amplifying operation.

As described above, instead of the conventional AC bias driving, by intermittently driving the magnetic impedance elements with pulses as exemplified in FIG. 6 (a) and (c), it is possible to lower the power consumption further than in the case of the conventional method of continuously driving them.

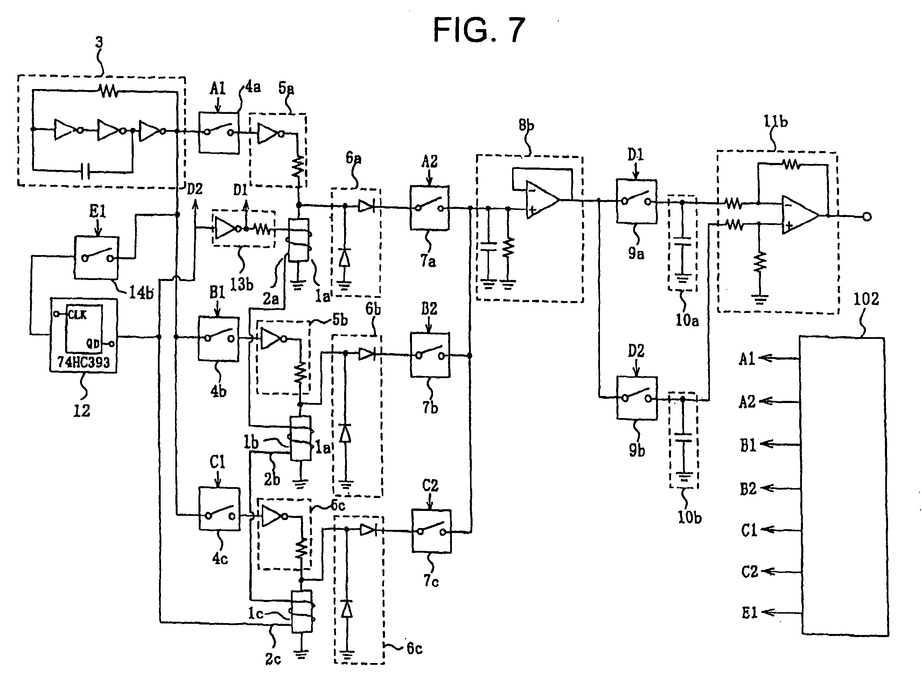

FIG. 7 presents a concrete example of the circuit shown in FIG. 5. In contrast with that shown in FIG. 4, the circuit shown in FIG. 7 corresponds to that added using a second holding means 10a and 10b, a differential amplifying means 11b, and a frequency-dividing means 12. However, in this example, the second holding means 10a and 10b are constituted with capacitors. The differential amplifying means 11b is constituted with a differential amplifier of an operational amplifier. The frequency-dividing means 12 is constituted with a flip-flop.

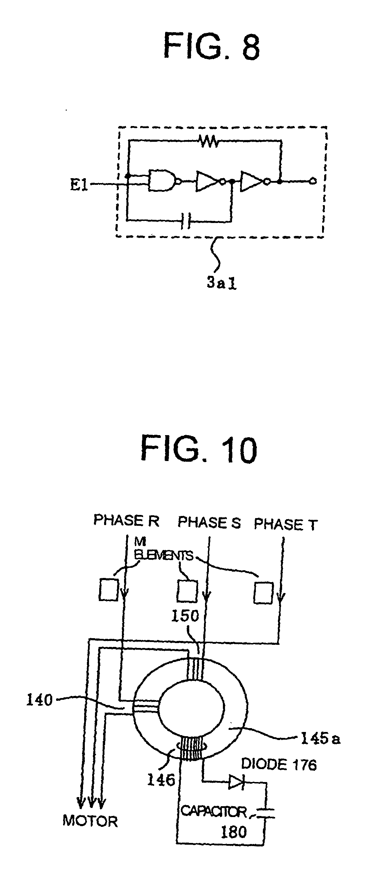

Further, in place of the oscillating means 3 shown in FIG. 4 and FIG. 7, as shown in FIG. 8 for example, by applying another one (3a1) capable of oscillating only when the control signal E1 remains at a High level so as to cause the third switch 14b and the oscillating means 3a1 to be turned On via the signal E1 only when one of the groups including the first switches 4a,4b, and 4c, and the second switches 7a, 7b, and 7c corresponding to individual power-source phases has turned ON, it is possible to further lower the power consumption.

The above description refers to a case in which the three-phase AC power-supply source is applied. In the case of a single phase, the invention can be applied simply by considering the scope of a single phase.

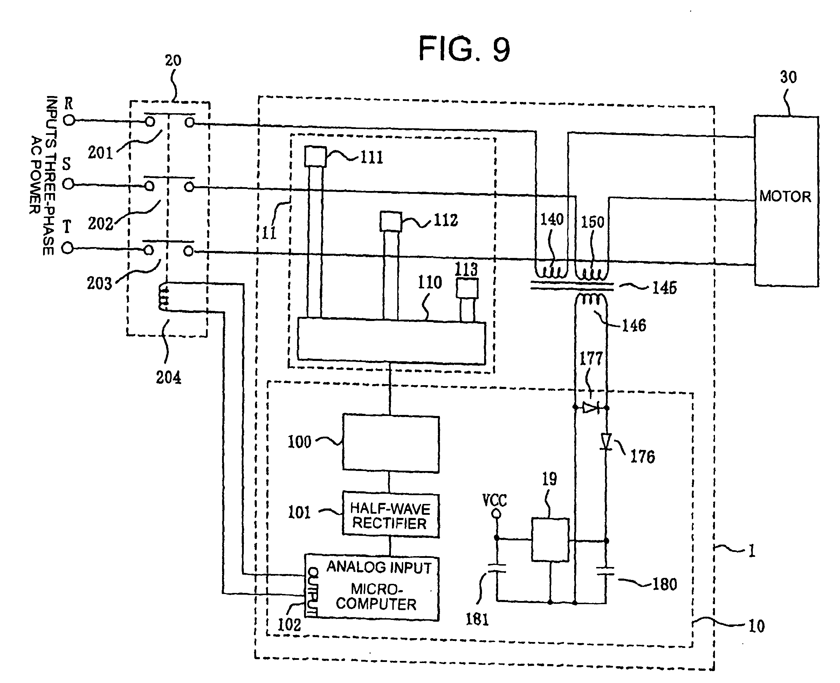

FIG. 9 is a schematic block diagram of the overload-current security device according to the second embodiment of the present invention.

The circuit shown in FIG. 1 requires the provision of power-supply transformers 161 and 162 corresponding to at least two phases. On the other hand, the circuit shown in FIG. 9 features the provision of a single core 145 to replace the primary coils 140 and 150 provided for each phase so as to receive power from the secondary coil 146, thereby eliminating the need for one of the two cores. Concretely, as shown in FIG. 10 for example, the core 145 is constituted with a toroidal core 145a. To ensure that a proper current level can be fed from the secondary coil 146, the winding ratio between the primary coils 140 and 150 is selected to be 1:2, for example. The winding rounds of the primary coils differ among individual phases. This is due to the fact that, if identical winding rounds are given, it is not possible to detect the vacant phase.

In the controlling power-supply source, a first capacitor 180 is linked with the secondary coil 146 via a rectifying diode 176. A protective diode 177 is connected between the anode of the rectifying diode 176 and the ground of the circuit. The first capacitor 180 is connected between the positive input terminal of the voltage adjuster 19 and the ground of the circuit. The second capacitor 181 is connected between the positive output terminal of the voltage adjuster 19 and the ground of the circuit. The voltage adjuster 19 outputs a constant voltage level VCC.

The other components shown in FIG. 9 are identical to those shown in FIG. 1; thus, further descriptions are omitted.

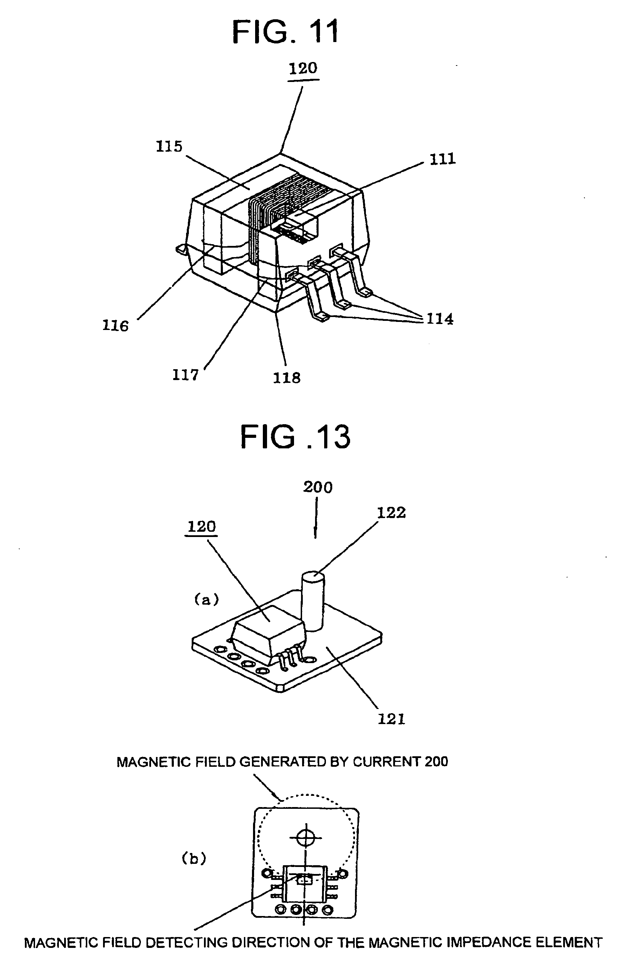

Referring to FIG. 11, the concrete constitution of the magnetic sensor used as described above is described below.

In FIG. 11, the reference numeral 111 designates a thin-film magnetism detection element, 115 a resinous bobbin formed on the outside of the magnetism detection element 111, which is produced via an insert-molding process. The reference numeral 116 designates a coil for adding a bias magnetic field to the magnetism detection element 111, 117, a coil for adding a negative-feedback magnetic field to the magnetism detection element 111, and 118 designates a resinous case for protecting the magnetism detection element 111 and the coils 116 and 117 from environmental hazards, where the case 118 is also produced via an insert-molding process. The reference numeral 114 designates terminals for adding high-frequency current to both ends of the magnetism detection element 111, and also for adding current to the coils 116 and 117. The entire constitution of the magnetic sensor is designated by the reference numeral 120. In the constitution shown in FIG. 11, a coil is provided for adding a negative-feedback magnetic field to the magnetism detection element 111. However, the coil may be deleted.

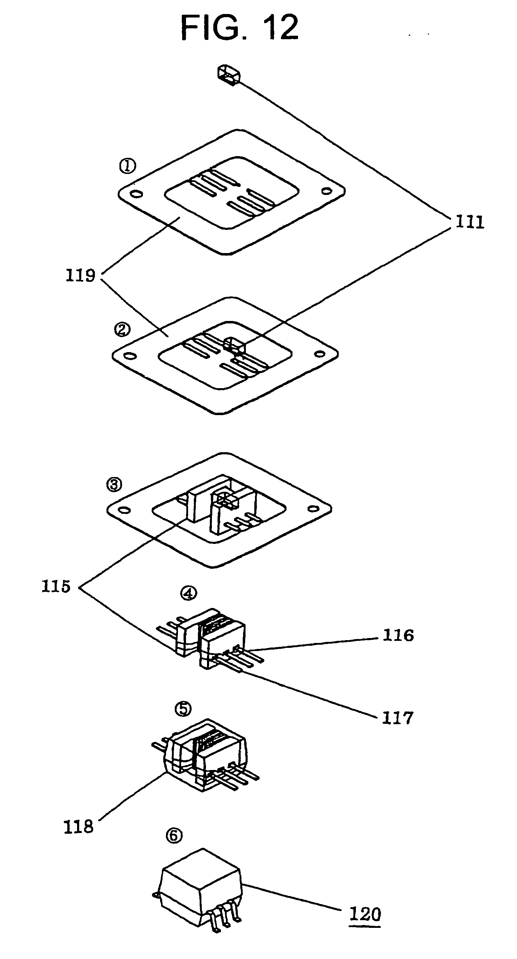

FIG. 12 shows an example of the flow of the assembly of magnetic sensor components.

Initially, as shown in ②, a magnetism detection element 111 is bonded between a group of terminals of the lead frame 119 shown in ①. The bonding method includes a soldering process, an adhesive process, and bonding. Next, as shown in ③, a bobbin 115 is integrally resin-molded with a lead frame 119 united with the magnetism detection element 111. Next, as shown in ④, after the lead frame 119 is cut off, a bias coil 116 and a negative-feedback coil 117 are wound. Next, as shown in ⑤, a case 118 is resin-molded directly above the coil unit. Next, as shown in ⑥, terminals 114 are folded to complete the assembly work.

It is possible to form a thin-film-applied magnetism detection element into a substantially 1-mm square configuration, and thus it is possible to form the magnetic sensor 120 into a substantially 5-mm square configuration; accordingly, it is possible to sharply decrease the magnetic resistance between the magnetic detection element 111 and the coils 116 and 117.

FIG. 13 shows an example of the loaded magnetic sensor, wherein FIG. 13 (a) is a perspective view and FIG. 13 (b) a plan view.

As shown in FIG. 13 (a), the magnetic sensor 120 is loaded on a substrate 121 fitted with wiring 122 for conducting current 200. Due to the arrangement of the magnetic sensor 120 in relation to the magnetic flux indicated by the dotted line in (b) generated by the current 200, the output sensitivity of the magnetic sensor 120 is determined. Thus, by considering the arrangement of the magnetic sensor 120, it is possible to adjust the output sensitivity of the magnetic sensor 120.

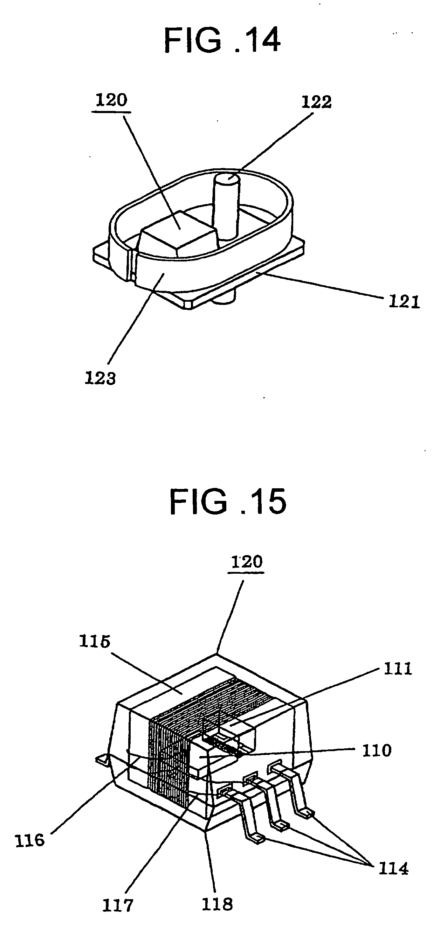

FIG. 14 shows an example of the magnetic shield structure, which comprises that shown in FIG. 11 with an added magnetic shield 123. Although the shield is elliptical in form, it is desirable that the form be properly arranged in correspondence with the magnitude of the current 200. The reference numeral 121 designates the substrate, and 122 the wiring.

FIG. 15 designates a concrete example of the magnetism detection unit, in which a detection circuit 110 has been incorporated (integrated) into the magnetic sensor unit shown in FIG. 11. As a result of this arrangement, it is possible to enhance the S/N ratio of the sensor signal. Further, by internally storing various types of corrective data used for automatic calibration as described in FIG. 6 for each magnetic sensor element, the precision can be further enhanced.

### INDUSTRIAL APPLICABILITY

In addition to application to the above-described overload-current security device, the present invention is also applicable to those general current detection devices for detecting the magnitude of the current flowing through a conductor, or those general breakers for breaking the current when the magnitude of the detected current has exceeded a pre-determined threshold value.

## Claims

1. An overload-current security device, comprising
a plurality of switching units (201-203) adapted to individually switch the current supplied from a power-supply source (RST) to a load (30);
a current detector (110-113) adapted to detect the current supplied from said power-supply source (RST) to said load (30); and
a controlling power-supply source (19, 161, 162, 171, 172) for supplying electrical power to each of said component elements; wherein
said overload-current security device is adapted to interrupt, upon detection of an overload-current, the power supplied to said load (30);
said current detector (110-113) comprises:
a plurality of magnetism detection elements (111-113; 1a-1c) that individually incorporate their own magnetic impedance effect and are arranged so as to be compatible with Individual phases of power-supply sources (RST);
an AC-current supply means adapted to supply AC current to each of said magnetism detection elements (111-113) via a respective one of first switches (4a-4c), the AC-current supply means comprising an oscillating means (3);
a bias-current supply means (2a-2c, 13a, 14a; 2a-2c, 12, 13b, 14b) that comprises a plurality of bias coils (2a-2c) individually wound on each of said magnetism detection elements (111-113), a third switch (14a; 14b), and a bias-current adding means (13a; 13b), wherein said bias-current supply means (2a-2c, 13a, 14a; 2a-2c, 12, 13b, 14b) is arranged to supply current to each of said bias coils (2a-2c) via said third switch (14a; 14b);
a plurality of wave detection means (6a-6c) that are Individually disposed in correspondence with each of said magnetism detection elements (111-113) and individually function so as to convert Impedance variations of the magnetism detection elements (111-113) into voltages, and to output the peak voltages;
a plurality of second switches (7a-7c) each disposed In correspondence with a respective one of said wave detection means (6a-6c), the second switches being adapted to selectively output said peak voltage from each of said wave detection means (6a-6c);
a holding means (8a; 8b) adapted to individually hold the output from a selected one of said wave detection means; and
an amplifying means (11a; 11b) adapted to amplify the voltage held by said holding means (8a; 8b);
wherein said overload-current security device enables said current detector (110-113) to detect the current for each individual phase based on selective operations performed by said first, and second switches (4a-4c, 7a-7c) and said third switch (14a; 14b).

2. An overload-current security device according to claim 1
wherein the bias-current supply means (2a-2c, 12, 13b) further comprises a frequency-dividing means (12) connected to said oscillating means (3) via said third switch (14b) and adapted to frequency-divide the output from said oscillating means (3), wherein said bias-current supply means (2a-2c, 12, 13b) is adapted to supply current having different polarities to each of said bias coils (2a-2c) In accordance with first and second timings, respectively;
said holding means has a first holding means (8b);
two second holding means (10a, 10b); and
two fourth switches (9a, 9b) arranged between the output of said first holding means (8b) and said two second holding means (10a, 10b), each fourth switch (9a, 9b) being controlled in accordance with a respective one of said first and second timings to selectively apply the voltage value held by said first holding means (8b) to one of said two second holding means (10a, 10b);
wherein said amplifying means (11b) is arranged to amplify the difference in the voltage values output from said two second holding means (10a, 10b); and
wherein said overload-current security device enables said current detector to detect the current for each individual phase based on selective operations performed by said first, second, third, and fourth switches.

3. An overload-current security device according to Claim 1 or 2 wherein, when said first and second switches (4a-4c, 7a-7c) corresponding to any of said magnetism detection elements (111-113) disposed in a corresponding power-supply phase have been selected, said third switch (14a; 14b) Is selected.

4. An overload-current security device according to any one of Claims 1 to 3, wherein said oscillating means (3) is operated synchronously with said third switch (14a; 14b).

5. An overload-current security device according to any one of Claims 1 to 4, wherein said controlling power-supply source (19, 161, 162, 171, 172) comprises the following: at least a pair of power-supply transformers (161, 162) each having a primary and a secondary coil and being connected to a corresponding one of current-supply lines connecting said power-supply source (RST) to said load (30); a capacitor (180) that stores current supplied to said secondary coils; and a voltage adjuster (19).

6. An overload-current security device according to Claim 5, wherein said controlling power-supply source (19, 161, 162, 171, 172) comprises : at least one power-supply transformer having at least two primary coils (140, 150) and one secondary coil (146) wound on a single iron core (145), the primary coils (140, 150) being each connected to a corresponding one of current-supply lines connecting said power-supply source (RST) to said load (30); a capacitor (180) that stores current supplied to said secondary coil (146); and a voltage adjuster (19), wherein the numbers of turns of said primary coils (140, 150) differ from each other.

7. An overload-current security device according to Claim 6, wherein the winding ratio between said primary coils (140, 150) is 1:2.

8. An overload-current security device according to any one of the preceding Claims, wherein said magnetism detection elements (111-113), terminals for adding AC current to said magnetism detection elements (111-113), said bias coils (2a-2c), and other terminals for supplying bias current to said bias coils (2a-2c) are jointly integrated through a resin-molding process.

9. An overload-current security device according to any one of Claims 1 to 8, wherein said magnetism detection elements (111-113), terminals for adding AC current to said magnetism detection elements (111-113), said bias coils (2a-2c), other terminals for supplying bias current to said bias coils (2a-2c), and a circuit that outputs signal proportional to the output signal from said magnetism detection elements (111-193), are jointly integrated through a resin-molding process.

10. An overload-current security device according to any one of the preceding Claims, wherein thin-flim-configured elements are used for constituting said magnetism detection elements (111-113).

## Patentansprüche

1. Überlaststrom-Schutzvorrichtung, die aufweist
eine Vielzahl von Schaltelnheiten (201-203), die ausgebildet sind, einzeln den Strom zu schalten, der von einer Stromversorgungsquelle (RST) zu einer Last (30) geliefert wird;
einen Stromerfasser (110-113), der ausgebildet ist, den Strom zu erfassen, der von der Stromversorgungsquelle (RST) zu der Last (30) geliefert wird; und
eine Steuerungs-Stromversorgungsquelle (19, 161, 162, 171, 172) zum Liefern von elektrischer Leistung an jedes der Komponentenelemente; wobei
die Überlaststrom-Schutzvorrichtung ausgebildet ist, bei Erfassung eines Überlaststroms, den Strom zu unterbrechen, der an die Last (30) geliefert wird;
wobei der Stromerfasser (110-113) aufweist:
eine Vielzahl von Magnetismuserfassungselementen (111-113; 1a-1c), die einzeln Ihren eigenen magnetischen Impedanzeffekt enthalten und ausgebildet sind, mit einzelnen Phasen von Stromversorgungsquellen (RST) kompatibel zu sein;
ein Wechselstram-Liefermittel, das ausgebildet ist, einen Wechselstrom an jedes der Magnetismuserfassungselemente (111-113) über einen jeweiligen von ersten Schaltern (4a-4c) zu liefern, wobei das Wechselstrom-Liefermittel ein Oszillatormittel (3) aufweist;
ein Blas-Strom-Liefermittel (2a-2c, 13a, 14a; 2a-2c 12, 13b, 14b), das eine Vielzahl von Blas-Spulen (2a-2c) aufweist, die einzeln gewickelt sind auf jedes der Magnetismuserfassungselemente (111-113), einen dritten Schalter (14a; 14b) und ein Bias-Strom-Hinzufügungsmittel (13a; 13b), wobei das Blas-Strom-Liefermittel (2a-2c, 13a, 14a; 2a-2c 12, 13b, 14b) ausgebildet ist, Strom an Jede der Bias-Spulen (2a-2c) über den dritten Schalter (14a; 14b) zu liefern;
eine Vielzahl von Wellenerfassungsmitteln (6a-6c), die einzeln in Entsprechung zu jedem der Magnetismuserfassungselemente (111-113) angeordnet sind und einzeln funktionieren, um Impedanzvariationen der Magnetismuserfassungselemente (111-113) in Spannungen umzuwandeln und die Spltzenspannungen auszugeben;
eine Vielzahl von zweiten Schaltern (7a-7c), die jeweils in Entsprechung zu einem jeweiligen der Wellenerfassungsmittel angeordnet sind, wobei die zweiten Schalter ausgebildet sind, die Spitzenspannung von jedem der Wellenerfassüngsmittel (6a-6c) selektiv auszugeben;
ein Haltemittel (8a; 8b), das ausgebildet Ist, die Ausgabe von einem ausgewählten der Wellenerfassungsmittel einzeln zu halten; und
ein Verstärkungsmittel (11a; 11b), das ausgebildet ist, die Spannung zu verstärken, die von dem Haltemittel (8a: 8b) gehalten wird;
wobei die Überlaststrom-Schutzvorrichtung dem Stromerfasser (110-113) ermöglicht, den Strom für jede einzelne Phase zu erfassen basierend auf selektiven Operationen, die durch die ersten und zweiten Schalter (4a-4c, 7a-7c) und den dritten Schalter (14a; 14b) durchgeführt werden.

2. Überlaststrom-Schutzvorrichtung gemäß Anspruch 1,
wobei das Bias-Strom-Liefermittel (2a-2c, 12, 13b) weiter ein Frequenzteilungsmittel (12) aufweist, das mit dem Oszillatormittel (3) über den dritten Schalter (14b) verbunden ist und ausgebildet ist, die Ausgabe von dem Oszillatormittel (3) in der Frequenz zu teilen, wobei das Bias-Strom-Liefermittel (2a-2c, 12, 13b) ausgebildet ist, Strom, der unterschiedliche Polaritäten hat, an jede der Blas-Spulen (2a-2c) in Übereinstimmung jeweils mit ersten und zweiten Timings zu liefern;
wobei das Haltemittel ein erstes Haltemittel (8b) hat;
zwei zweite Haltemittel (10a, 10b); und
zwei vierte Schalter (9a, 9b), die zwischen dem Ausgang des ersten Haltemiltels (8b) und den zwei zweiten Haltemitteln (10a, 10b) ausgebildet sind, wobei jeder vierte Schalter (9a, 9b) In Übereinstimmung mit einem jeweiligen der ersten und zweiten Timings gesteuert wird, um selektiv den Spannungswert, der von dem ersten Haltemittel (8b) gehalten wird, auf eines der zwei zweiten Haltemittel (10a, 10b) anzuwenden; und
wobei die Überlaststrom-Schutzvorrichtung dem StromerFasser ermöglicht, den Strom für jede einzelne Phase zu erfassen basierend auf selektiven Operationen, die durch die ersten, zweiten, dritten und vierten Schalter durchgeführt werden.

3. Überlaststrom-Schutzvorrichtung gemäß Anspruch 1 oder Anspruch 2, wobei, wenn die ersten und zweiten Schalter (4a-4c, 7a-7c), die einem der Magnetismuserfassungselemente (117-113) entsprechen, die in einer entsprechenden Stromversorgungsphase angeordnet sind, ausgewählt werden, der dritte Schalter (14a; 14b) ausgewählt wird.

4. Überlaststrom-Schutzvorrichtung gemäß einem der Ansprüche 1 bis 3, wobei das Oszillatormittel (3) synchron mit dem dritten Schalter (14a; 14b) betrieben wird.

5. Oberlaststrom-Schutzvorrichtung gemäß einem der Ansprüche 1 bis 4, wobei die Steuerungs-Stromversorgungsquelle (19, 161, 162, 171, 172) folgendes aufweist: zumindest ein Paar von Stromversorgungswandlern (161, 162), die jeweils eine primäre und eine sekundäre Spule haben und mit einer entsprechenden von Stromversorgungsleitungen verbunden sind, die die Stromversorgungsquelle (RST) mit der Last (30) verbinden; einen Kondensator (180), der Strom speichert, der an die sekundären Spulen geliefert wird: und einen Spannungsanpasser (19).

6. Überlaststrom-Schutzvorrichtung gemäß Anspruch 5, wobei die Steuerungs-Stromversorgungsquelle (19, 161, 162, 171, 172) aufweist: zumindest einen Stromversorgungswandler mit zumindest zwei primären Spulen (140, 150) und einer sekundären Spule (146), die auf einem einzelnen Eisenkern (145) gewickelt sind, wobei die primären Spulen (140, 150) jeweils mit einer entsprechenden von Stromversorgungsleitungen verbunden sind, die die Stromversorgungsquelle (RST) mit der Last (30) verbinden; einen Kondensator (180), der Strom speichert, der an die sekundäre Spule (146) geliefert wird; und einen Spannungsanpasser (19), wobei sich die Anzahl von Wicklungen der primären Spulen (140, 150) voneinander unterscheiden.

7. Überlaststrom-Schutzvorrichtung gemäß Anspruch 6, wobei das Wicklungsverhältnis zwischen den primären Spulen (140, 150) 1:2 ist.

8. Überlaststrom-Schutzvorrichtung gemäß einem der vorhergehenden Ansprüche, wobei die Magnetismuserfassungselemente (111-113). Anschlüsse zum Zuführen von Wechselstrom zu den Magnetismuserfassungselementen (111-113), die Bias-Spulen (2a-2c) und andere Anschlüsse zum Liefern von Bias-Strom an die Bias-Spulen (2a-2c) durch ein Kunstharzformverfahren miteinander Integriert sind.

9. Überlaststrom-Schutzvorrichtung gemäß einem der Ansprüche 1 bis 8, wobei die Magnetismuserfassungselemente (111-113), Anschlüsse zum Zuführen von Wechselstrom zu den Magnetismuserfassungselementen (111-113), die Blas-Spulen (2a-2c), andere Anschlüsse zum Liefern von Bias-Strom an die Bias-Spulen (2a-2c) und eine Schaltung, die ein Signal proportional zu dem Ausgabesignal von den Magnetismuserfassungselementen (111-113) ausgibt, durch ein Kunstharzformverfahren miteinander integriert sind.

10. Überlaststrom-Schutzvorrichtung gemäß einem der vorhergehenden Ansprüche, wobei mit Dünnschicht konfigurierte Elemente als die Magnetismuserfassungselemente (111-113) verwendet werden.

## Revendications

1. Dispositif de sécurité vis-à-vis d'un courant de surcharge, comprenant
une pluralité d'unités (201 à 203) de commutation conçues pour commuter individuellement le courant envoyé d'une source (RST) d'alimentation en courant à une charge (30) ;
un détecteur (110 à 113) de courant conçu pour détecter le courant envoyé de la source (RST) d'alimentation en courant à la charge (30) ; et
une source (19, 161, 162, 171, 172) d'alimentation en courant de commande pour fournir du courant électrique à chacun des éléments de composant ; dans lequel
le dispositif de sécurité vis-à-vis d'un courant de surcharge est conçu pour interrompre, après détection d'un courant de surcharge, le courant envoyé à la charge (30) ;
et le détecteur (110 à 113) de courant comprend :
une pluralité d'éléments (111 à 113, 1a à 1c) de détection de magnétisme, qui incorpore individuellement leur propre effet d'impédance magnétique et sont agencés pour être compatibles avec des phases individuelles de sources (RST) d'alimentation en courant ;
un moyen d'alimentation en courant alternatif conçu pour fournir du courant alternatif à chacun des éléments (111 à 113) de détection de magnétisme par l'un respectif de premiers commutateurs (4a à 4c), les moyens d'alimentation en courant alternatif comprenant un moyen (3) oscillant :
un moyen (2a à 2c, 13a, 14a ; 2a à 2c, 12, 13b, 14b) d'alimentation en courant polarisé qui comprend une pluralité de bobines (2a à 2c) polarisées enroulées individuellement sur chacun des éléments (111 à 113) de détection de magnétisme, un troisième commutateur (14a ; 14b) et un moyen (13a, 13b) d'addition de courant polarisé, dans lequel le moyen (2a à 2c, 13a, 14a ; 2a à 2c, 12, 13b, 14b) d'alimentation en courant polarisé est conçu pour fournir du courant à chacune des bobines (2a à 2c) polarisées par l'intermédiaire du troisième commutateur (14a ; 14b) ;
une pluralité de moyens (6a à 6c) de détection d'ondes, qui sont disposés individuellement en correspondance avec chacun des éléments (111 à 113) de détection de magnétisme et qui fonctionnement individuellement, de manière à convertir des variations d'impédance des éléments (111 à 113) de détection de magnétisme en des tensions, et à émettre en sortie les tensions de crête ;
une pluralité de deuxièmes commutateurs (7a à 7c) disposés chacun en correspondance avec l'un respectif des moyens (6a à 6c) de détection d'ondes, les deuxièmes commutateurs étant conçus pour émettre en sortie sélectivement la tension de crête de chacun des moyens (6a à 6c) de détection d'ondes ;
un moyen (8a, 8b) de maintien conçu pour maintenir individuellement la sortie de l'un sélectionné des moyens de détection d'ondes ; et
un moyen (11a ; 11b) d'amplification conçu pour amplifier la tension maintenue par le moyen (8a, 8b) de maintien ;
dans lequel le dispositif de sécurité vis-à-vis d'un courant de surcharge permet au détecteur (110 à 113) de courant de détecter le courant pour chaque phase individuelle sur la base d'opérations sélectives effectuées par les premiers et deuxièmes commutateurs (4a à 4c, 7a à 7c) et le troisième commutateur (14a ; 14b).

2. Dispositif de sécurité vis-à-vis d'un courant de surcharge suivant la revendication 1,
dans lequel le moyen (2a à 2c, 12, 13b) d'alimentation en courant polarisé comprend, en outre, un moyen (12) de division de fréquence connecté au moyen (3) oscillant par l'intermédiaire du troisième commutateur (14b) et conçu pour diviser en fréquence la sortie du moyen (3) oscillant, le moyen (2a à 2c, 12, 13b) d'alimentation en courant polarisé étant conçu pour fournir du courant ayant des polarités différentes à chacune des bobines (2a à 2c) polarisées en fonction de première et deuxième cadences respectivement ;
le moyen de maintien ayant un premier moyen (8b) de maintien ;
deux deuxièmes moyens (10a, 10b) de maintien ; et
deux quatrièmes commutateurs (9a, 9b) montés entre la sortie du premier moyen (8b) de maintien et les deux deuxièmes moyens (10a, 10b) de maintien, chaque quatrième commutateur (9a, 9b) étant commandé en fonction de l'une respective des première et deuxième cadences pour appliquer sélectivement la valeur de tension maintenue par le premier moyen (8b) de maintien à l'un des deux deuxièmes moyens (10a, 10b) de maintien ;
dans lequel le moyen (11b) amplificateur est monté pour amplifier la différence entre les valeurs de tension de sortie des deux deuxièmes moyens (10a, 10b) de maintien ; et
dans lequel le dispositif de sécurité vis-à-vis d'un courant de surcharge permet au détecteur de courant de détecter le courant pour chaque phase individuelle sur la base d'opérations sélectives effectuées par les premier, deuxième, troisième et quatrième commutateurs.

3. Dispositif de sécurité vis-à-vis d'un courant de surcharge suivant la revendication 1 ou 2, dans lequel lorsque le premier et deuxième commutateurs (4a à 4c, 7a à 7c) correspondant à n'importe lequel des éléments (111 à 113) de détection de magnétisme disposés dans une phase correspondante d'alimentation en courant ont été sélectionnés, le troisième commutateur (14a ; 14b) est sélectionné.

4. Dispositif de sécurité vis-à-vis d'un courant de surcharge suivant l'une quelconque des revendications 1 à 3, dans lequel le moyen (3) oscillant est mis en fonctionnement en synchronisme avec le troisième commutateur (14a ; 14b).

5. Dispositif de sécurité vis-à-vis d'un courant de surcharge suivant l'une quelconque des revendications 1 à 4, dans lequel la source (19, 161, 162, 171, 172) d'alimentation en courant de commande comprend ce qui seuil : au moins une paire de transformateurs (161, 162) d'alimentation en courant, chacun ayant une bobine primaire et une bobine secondaire, et étant connectés à l'une correspondante de lignes d'alimentation en courant reliant la source (RST) d'alimentation en courant à la charge (30) ; un condensateur (180) qui emmagasine du courant fourni aux bobines secondaires ; et un ajusteur (19) de tension.

6. Dispositif de sécurité vis-à-vis d'un courant de surcharge suivant la revendication 5, dans lequel la source (19, 161, 162, 171, 172) d'alimentation en courant de commande comprend : au moins un transformateur d'alimentation en courant ayant au moins deux bobines (140, 150) primaires et une bobine (146) secondaire enroulées sur un noyau (145) unique de fer, les bobines (140, 150) primaires étant connectées chacune à l'une correspondante de lignes d'alimentation en courant reliant la source (RST) d'alimentation en courant à la charge (30) ; un condensateur (180) qui emmagasine du courant fourni à la bobine (146) secondaire ; et un ajusteur (19) de tension, dans lequel le nombre de spires des bobines (140, 150) primaires diffère d'une bobine à l'autre.

7. Dispositif de sécurité vis-à-vis d'un courant de surcharge suivant la revendication 6, dans lequel le rapport de bobinage entre les bobines (140, 150) primaires est de 1:2.

8. Dispositif de sécurité vis-à-vis d'un courant de surcharge suivant l'une quelconque des revendications précédentes, dans lequel les éléments (111 à 113) de détection de magnétisme, des bornes pour ajouter du courant alternatif aux éléments (111 à 113) de détection de magnétisme, les bobines (2a à 2c) de polarisation et d'autres bornes pour envoyer du courant polarisé aux bobines (2a à 2c) de polarisation sont intégrés conjointement par une opération de moulage par de la résine.

9. Dispositif de sécurité vis-à-vis d'un courant de surcharge suivant l'une quelconque des revendications 1 à 8, dans lequel les éléments (111 à 113) de détection de magnétisme, des bornes pour ajouter du courant alternatif aux éléments (111 à 113) de détection de magnétisme, les bobines (2a à 2c) de polarisation, d'autres bornes pour envoyer du courant polarisé aux bobines (2a à 2c) de polarisation et un circuit qui émet en sortie un signal proportionnel au signal de sortie des éléments (111 à 113) de détection de magnétisme sont intégrés conjointement par une opération de moulage par de la résine.

10. Dispositif de sécurité vis-à-vis d'un courant de surcharge suivant l'une quelconque des revendications précédentes, dans lequel des éléments configurés en couche mince sont utilisés pour constituer les éléments (111 à 113) de détection de magnétisme.
